Europäisches Patentamt

European Patent Office

Office européen des brevets

Publication number: **0 300 475**
**A2**

## EUROPEAN PATENT APPLICATION

(21) Application number: 88111734.5

(51) Int. Cl.⁴: **G03F 1/00**

(22) Date of filing: 21.07.88

(30) Priority: 24.07.87 US 77497

(43) Date of publication of application:
**25.01.89 Bulletin 89/04**

(84) Designated Contracting States:
**BE CH DE FR GB IT LI NL SE**

(71) Applicant: **E.I. DU PONT DE NEMOURS AND COMPANY**
**1007 Market Street**
**Wilmington Delaware 19898(US)**

(72) Inventor: **Vitale, Americus Christopher**
**758 Beversrede Trail**
**West Chester Pennsylvania 19382(US)**

(74) Representative: **Werner, Hans-Karsten, Dr. et al**
**Deichmannhaus am Hauptbahnhof**
**D-5000 Köln 1(DE)**

(54) Method for obtaining ultrathin protected phototools.

⑤ A process of imagewise exposure to actinic radiation involves using a phototool having an adherent protective layer.

# METHOD FOR OBTAINING ULTRATHIN PROTECTED PHOTOTOOLS

## BACKGROUND OF THE INVENTION

The present invention is directed to a method of obtaining a thin protective layer on a phototool useful for imagewise exposure of a photosensitive surface to actinic radiation.

U.S. Patent 4,077,830 discloses utilization of a protective sheet having a pressure sensitive adhesive coating secured to an emulsion surface of a photographic element. This publication sets forth a conventional laminate of a sheet material coated with a pressure sensitive adhesive is generally known but is unsatisfactory for covering photographic elements. This laminate is too thick, is not of sufficient optical clarity and, is not sufficiently smooth. This patent discloses formation of an improved protective covering of a Mylar® polyester with an adhesive coating whereby the total thickness is less than 0.004 inches. Additionally to obtain the optical clarity desired both the protective sheet and the release sheet have a surface finish of less than ten millionths of an inch RMS so that both the adhesive surface and the protective sheet surface are very smooth when the release sheet is stripped away.

U.S. Patent 3,397,980 discloses formation of a laminate of a photographic film having microimages and provided with a protective transparent laminate overlay whereby both layers are formed from polyethylene bonded with an intermediate layer of polyvinyl acetate.

## SUMMARY OF THE INVENTION

The present invention is directed to a method of imagewise exposure to actinic radiation of a photosensitive layer applied to a substrate followed by removal of similar areas of the layer from the substrate wherein the exposure involves passage of actinic radiation through a phototool having transparent and opaque portions whereby the phototool has an adherent protective film on one surface thereof
wherein the improvement is present in formation of the phototool and comprises the steps of:

(a) applying to a phototool by pressure contact a supported adhesive layer with the adhesive having a thickness not greater than 0.25 mil with the support separated from the adhesive immediately after pressure contact;

(b) applying to the adhesive layer by pressure contact a protective film having a thickness not greater than 0.25 mil; whereby the total thickness of the adhesive and protective film is not greater than 0.50 mil.

## DRAWING

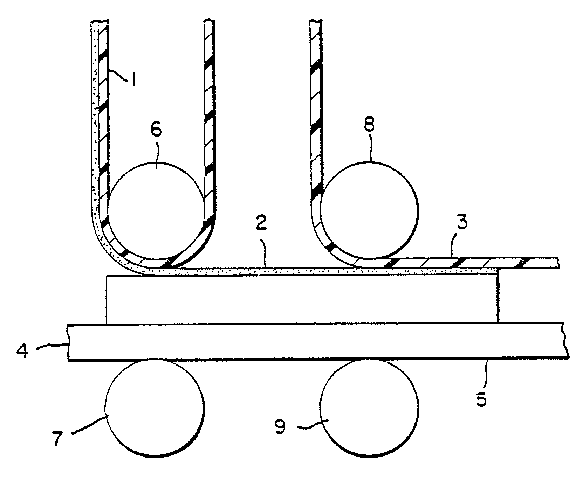

The Figure is a schematic presentation of the process of applying an adhesive layer and a protective film to a surface of a phototool.

## DETAILED DESCRIPTION OF THE INVENTION

The technology which the present invention relates is well-known in the prior art. It employs use of a phototool having opaque and nonopaque image areas with a protective covering film to protect a surface of the phototool. Actinic radiation passes through the nonopaque areas while the opaque areas block the passage of its radiation. The actinic radiation thereafter projects upon a surface of a photosensitive material such as a photoresist which can be either positive working or negative working. Useful photosensitive materials and their methods of use are well known in the prior art such as disclosed in Printed Circuits Handbook Edited by Clyde F. Combs, Jr. (Second Edition 1979) McGraw Hill Book Company in Chapters 6, 7 and 8 as well as in "Photoresist Materials & Processes" by William S. DeForest, 1979, McGraw Hill Book Company. Dependent upon the sensitive material either the areas which have been exposed to actinic radiation or the areas which have not been exposed to actinic radiation are readily removed in a procedure known as development. The areas remaining on the substrate allow further processing steps such as those utilized in making a printed circuit board wherein a conductive layer is present on an insulating surface is either plated or etched.

In the present invention an improved process is disclosed for making a phototool having a protective surface covering. The purpose of the phototool is like prior art phototools namely to maximize the optical quality of the phototool such that actinic radiation passes through areas on a phototool which are transparent to actinic radiation. Obviously if the phototool is not of high optical transparency passage of actinic radiation is impeded or distorted.

In the present invention the materials of construction the phototool and its protective covering sheet are known in the prior art and include a protective covering, an adhesive layer and the phototool itself. However what is unique in the present invention is the method which allows the materials to be applied in an ultrathin construction which aids in preventing optical distortion.

In the present invention a protective covering is applied to a surface of a phototool using an adhesive layer. The method of application may be described with reference to the accompanying Figure. An adhesive layer 2 which is optically transparent is present on a backing film 1 which allows the adhesive to be transferred by pressure contact to phototool 4 employing pressure rollers 6 and 7 respectively which are on opposite sides of a support film for the adhesive and a carrier 5 for the phototool. The backing film can be of relatively thick construction compared to the protective film (although both of these materials can be of the same material such as Mylar® polyester). The backing film is preferably coated with a release coating such as silicone which facilitates removal of the adhesive from the backing film. An exemplary thickness of this backing film is of the order of 1.00 mil. The phototool to which the adhesive is applied may be of conventional construction and can include the following materials: silver halide or diazo photographic emulsions which are supported on polyester or acetate films or glass plates, also, metallized images on the above mentioned supports. Criticality is present herein in the maximum thickness of the adhesive since as a practical matter the thicker the adhesive the greater will be the tendency to have an adverse effect on the overall optical clarity of the phototool when used to transmit actinic radiation. The adhesive layer generally will not be greater than 0.25 mil and more preferably not greater than 0.15 mil. Known pressure sensitive adhesive coatings which are well-known in the prior art can likewise be employed in the present technique disclosed herein. Examples of such adhesive are water based or organic solvent based acrylic adhesives. Criticality is not present in the composition of the adhesive provided it meets the above named limitations.

After application of the adhesive as a continuous film onto the phototool a thinner gauge protective layer 3 is laminated onto the adhesive bearing phototool by use of pressure rollers 8 and 9 which are on opposite sides of the protective film and the support bearing the phototool. The protective film of conventional material such as Mylar® polyester is optically transparent. Its thickness is minimized and generally will not be greater than 0.25 mil and more preferably not greater than 0.20 mil.

After formation of the phototool with its protective surface covering an overall article is formed which will not be greater than 0.50 mil in thickness and more preferably not greater than 0.40 mil. Thereafter the phototool is employed in a known manner with its protective surface covering.

A preferred use of photosensitive compositions are as photoresists or solder masks such in making a printed circuit board. Such techniques are conventional in the art employing a solid material, e.g., U.S. Patent 3,469,982. The process is directed to laminating a photosensitive or a substrate comprising:

(a) laminating to the substrate a supported solid photosensitive film,

(b) imagewise exposing the layer to actinic radiation,

(c) removing unexposed areas (or exposed areas in the case of a positive working film) of the layer to form resist areas,

(d) permanently modifying areas of the substrate which are unprotected by the resist areas by etching the substrate or by depositing a material onto the substrate. The support is conventionally removed before or after the exposure step. In the case of solder mask utility the step of depositing a material can be by application of solder. In a utility not involving direct use as a solder mask in initial application to a substrate (which is conductive with copper preferred circuitry therein) the resist areas are removed after step (d) which is conventional.

Preferably the laminating stations and feed rolls of coated adhesive and protective film are enclosed in a dust free chamber fed with filtered air to prevent oclusion of airborne particles into the adhesive during lamination. In this instance the phototool surfaces are precleaned by conventional means just prior to or at entry into the dust free chamber.

To further illustrate the present invention the following example is provided.

Two diazo phototools were laminated with ultrathin protector films of a thickness of 0.27 mils and 0.40 mils total thickness respectively. A 92 gauge silicone treater Mylar® S release sheet was coated with 0.15 mil thick acrylic pressure sensitive adhesive (3M Scotch-Grip® Industrial Adhesive 4914) using a Gardner knife. This thin adhesive layer was transferred using a FILMGUARD laminator under room temperature condition to two phototool emulsion surfaces, and the release sheet removed. A 12 gauge Mylar® C polyester film and a 25 gauge Mylar® S polyester film were laminated using a FILMGUARD laminator under room temperature conditions to the adhesive surface forming a 0.27 mil and 0.40 mil ultrathin protective laminate, respectively.

These protective laminates had no measurable effect on the UV/vis minimum optical density of the phototools. Measurements were made with an X-Rite® Model 339 UV vis Transmission Densitometer (X-Rite Co., Grand Rapids, Michigan).

## Claims

1. In a method of imagewise exposure to actinic radiation of a photosensitive layer applied to a substrate followed by removal of similar areas of the layer from the substrate wherein the exposure involves passage of actinic radiation through a phototool having transparent and opaque portions whereby the phototool has an adherent protective film on one surface thereof

wherein the improvement is present in formation of the phototool and comprises the steps of:

(a) applying to a phototool by pressure contact a supported adhesive layer with the adhesive having a thickness not greater than 0.25 mil with the support separated from the adhesive immediately after pressure contact;

(b) applying to the adhesive layer by pressure contact a protective film having a thickness not greater than 0.25 mil;

whereby the total thickness of the adhesive and protective film is not greater than 0.50 mil.

2. The method of claim 1 wherein pressure rollers are employed to apply the pressure contact of the adhesive to the phototool and the protective film.

3. The method of claim 1 wherein the adhesive layer and protective film are applied within a substantially dust free chamber to a precleaned phototool surface.